(19) **Europäisches Patentamt / European Patent Office / Office européen des brevets**

(11) **EP 4 451 560 B1**

(12) **EUROPEAN PATENT SPECIFICATION**

(45) Date of publication and mention of the grant of the patent:
**14.01.2026 Bulletin 2026/03**

(21) Application number: **22928700.8**

(22) Date of filing: **25.02.2022**

(51) International Patent Classification (IPC):
$H03F\ 1/32^{(2006.01)}$    $H03F\ 3/68^{(2006.01)}$
$H03F\ 1/34^{(2006.01)}$    $H03F\ 3/193^{(2006.01)}$
$H03F\ 3/21^{(2006.01)}$

(52) Cooperative Patent Classification (CPC):
**H03F 1/3205; H03F 1/3223; H03F 1/34; H03F 3/193; H03F 3/211;** H03F 2200/222; H03F 2200/387; H03F 2200/451

(86) International application number:
**PCT/JP2022/008013**

(87) International publication number:
**WO 2023/162173 (31.08.2023 Gazette 2023/35)**

(54) **LOW DISTORTION AMPLIFIER**

VERZERRUNGSARMER VERSTÄRKER

AMPLIFICATEUR À FAIBLE DISTORSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.10.2024 Bulletin 2024/43**

(73) Proprietor: **MITSUBISHI ELECTRIC CORPORATION**
**Chiyoda-ku**
**Tokyo 100-8310 (JP)**

(72) Inventors:
• **TAGUCHI, Marie**
**Tokyo 100-8310 (JP)**
• **KOMATSUZAKI, Yuji**
**Tokyo 100-8310 (JP)**
• **NAKATANI, Keigo**
**Tokyo 100-8310 (JP)**

(74) Representative: **Pfenning, Meinig & Partner mbB**
**Patent- und Rechtsanwälte**
**Theresienhöhe 11a**
**80339 München (DE)**

(56) References cited:
WO-A1-2017/085807    JP-A- 2010 506 514
US-A1- 2002 089 373    US-A1- 2006 181 344
US-A1- 2021 314 009

**Description**

TECHNICAL FIELD

The present disclosure relates to a low distortion amplifier.

BACKGROUND ART

In recent years, one amplifier for a fifth or sixth generation mobile communication base station is required to be applicable to a plurality of bands and to operate in an ultra-wide band in order to be used in large-capacity communication. Note that an amplifier operating with two modulated waves generates an intermodulation distortion between the modulated waves, and thus, it is necessary to reduce the intermodulation distortion. When an intermodulation distortion between modulated waves is generated, a band obtained by combining a low frequency side and a high frequency side is wider than a band of a generally widespread transceiver, and therefore digital distortion compensation (spurious suppression) cannot be applied.

For example, an amplifier circuit disclosed in Patent Literature 1 divides input signals of two modulated waves into a normal phase and a reverse phase, inputs the signals having phases different from each other to a first amplifier and a second amplifier, and combines input signals amplified by the first amplifier and the second amplifier. As a result, a signal (intermodulation distortion) of a frequency component generated by an intermodulation distortion, included in the output signal (fundamental wave) of the first amplifier is suppressed by a signal (intermodulation distortion) of a reverse characteristic in the frequency component, included in the output signal (fundamental wave) of the second amplifier.

US2021314009A1 discloses a method of a wireless transmitter. The method is for mitigation of distortion caused by non-linear hardware components of the transmitter, wherein mitigation of distortion comprises mitigating at least one intermodulation component, wherein the transmitter is configured to process an input signal having an input signal spectrum, and wherein the transmitter comprises two or more signal branches, each signal branch comprising a respective non-linear hardware component. The method comprises modifying the input signal for a first one of the signal branches by applying a first phase shift to a first part of the input signal spectrum, wherein the first phase shift has a first sign and a first absolute value, and applying a second phase shift to a second part of the input signal spectrum.

US2002089373A1 discloses a base station for a multi-carrier mobile communication system, which is equipped with an RF amplifier including input ports for inputting a plurality of input signals different in frequency of carrier from one another, dividers for respectively dividing each of the plurality of input signals inputted to the input ports into plural form, and phase shifters for respectively assigning a weight of phase to each of divided signals corresponding to a number obtained by subtracting 1 from the number of divisions.

CITATION LIST

PATENT LITERATURE

Patent Literature 1: JP 2007-243491 A

SUMMARY OF INVENTION

TECHNICAL PROBLEM

In the conventional technique disclosed in Patent Literature 1, with an amplitude difference between a fundamental wave signal output from the first amplifier and a fundamental wave signal output from the second amplifier, a ratio at which the fundamental wave signal is canceled is reduced as compared with an intermodulation distortion component in combining signals on an output side. However, this method has a problem that although power of the intermodulation distortion component with respect to power of the fundamental wave signal is reduced, the power of the fundamental wave signal is largely lost, and a highly efficient operation cannot be performed.

The present disclosure has been made in order to solve the above problems, and an object of the present disclosure is to obtain a low distortion amplifier capable of performing distortion compensation in which a ratio at which an intermodulation distortion component is suppressed is larger than a ratio at which a fundamental wave signal is deteriorated.

SOLUTION TO PROBLEM

The invention is defined by the appended set of claims. A low distortion amplifier according to the present disclosure includes: a first signal source that outputs a signal obtained by combining a first frequency signal and a second frequency signal, the second frequency being different from the first frequency; a second signal source that outputs a signal obtained by combining the first frequency signal and the second frequency signal; a first amplifier that receives the signal output from the first signal source and amplifies the input signal; a second amplifier that receives the signal output from the second signal source and amplifies the input signal; and a combiner that combines the signal amplified by the first amplifier and the signal amplified by the second amplifier, and operates in an operation mode in which a phase difference between the first frequency signals input to the first amplifier and the second amplifier and a phase difference between the second frequency signals input to the first amplifier and the second amplifier satisfy a relational equation in which an intermodulation distortion component included in the signal amplified by the first amplifier and an intermodulation distortion component included in the signal amplified by the second amplifier are in opposite phases.

ADVANTAGEOUS EFFECTS OF INVENTION

According to the present disclosure, an operation is performed in an operation mode in which a phase difference between the first frequency signals input to the first amplifier and the second amplifier and a phase difference between the second frequency signals input to the first amplifier and the second amplifier satisfy a relational equation in which an intermodulation distortion component included in the signal amplified by the first amplifier and an intermodulation distortion component included in the signal amplified by the second amplifier are in opposite phases. As a result, when the signal amplified by the first amplifier and the signal amplified by the second amplifier are combined, only the intermodulation distortion components included in these signals are combined in opposite phases, and therefore the low distortion amplifier according to the present disclosure can perform distortion compensation in which a ratio at which the intermodulation distortion component is suppressed is larger than a ratio at which a fundamental wave signal is deteriorated.

BRIEF DESCRIPTION OF DRAWINGS

FIG. 1 is a block diagram illustrating a configuration example of a low distortion amplifier according to a first embodiment.
FIG. 2 is a schematic diagram illustrating an outline of intermodulation distortion compensation in a first intermodulation distortion canceling operation mode.
FIG. 3 is a graph illustrating a change in an output power waveform of an output combiner in the first intermodulation distortion canceling operation mode.
FIG. 4 is a schematic diagram illustrating an outline of intermodulation distortion compensation in a second intermodulation distortion canceling operation mode.
FIG. 5 is a graph illustrating a change in an output power waveform of an output combiner in the second intermodulation distortion canceling operation mode.
FIG. 6 is a schematic diagram illustrating an outline of intermodulation distortion compensation in a third intermodulation distortion canceling operation mode.
FIG. 7 is a graph illustrating a change in an output power waveform of an output combiner in the third intermodulation distortion canceling operation mode.
FIG. 8 is a block diagram illustrating a configuration example of a low distortion amplifier according to a second embodiment.
FIG. 9 is a block diagram illustrating a configuration of a modification of the low distortion amplifier according to the second embodiment.
FIG. 10 is a block diagram illustrating a configuration example of a low distortion amplifier according to a third embodiment.
FIG. 11 is a block diagram illustrating a configuration of a modification of the low distortion amplifiers according to the first to third embodiments.

DESCRIPTION OF EMBODIMENTS

First Embodiment.

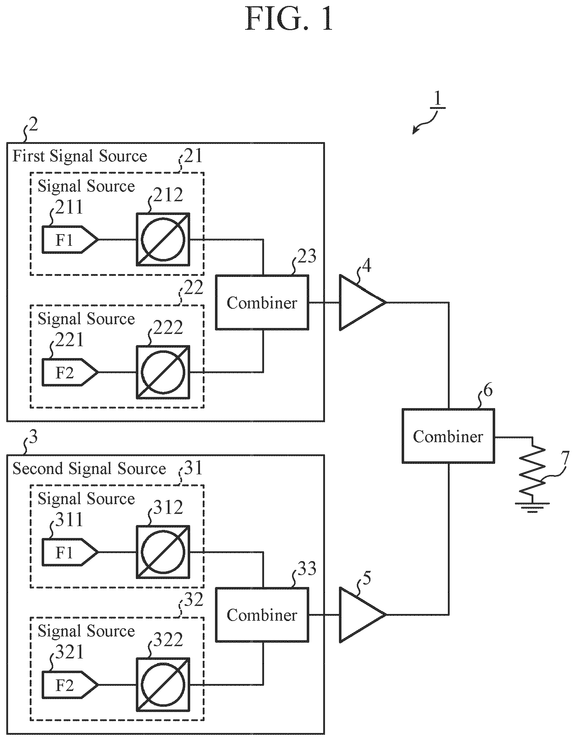

FIG. 1 is a block diagram illustrating a configuration example of a low distortion amplifier 1 according to a first embodiment. In FIG. 1, the low distortion amplifier 1 includes a first signal source 2, a second signal source 3, a first amplifier 4, a second amplifier 5, an output combiner 6, and an output terminal 7, and compensates for an intermodulation distortion in a signal output from the output combiner 6. The first signal source 2 includes a signal source 21, a signal source 22, and a first input combiner 23, and an output signal of the first input combiner 23 is input to the first amplifier 4. The signal source 21 is a signal source that generates a first frequency F1 signal (fundamental wave signal having the first frequency F1), and includes a signal generating unit 211 and a first phase shifter 212. The signal source 22 is a signal source that generates a second frequency F2 signal (fundamental wave signal having the second frequency F2), and includes a signal generating unit 221 and a second phase shifter 222. Note that, in FIG. 1 and drawings described below, the input combiner and the output combiner are simply referred to as combiners for simplicity of illustration of the drawings.

The second signal source 3 includes a signal source 31, a signal source 32, and a second input combiner 33, and an output signal of the second input combiner 33 is input to the second amplifier 5. The signal source 31 is a signal source that generates the first frequency F1 signal (fundamental wave signal having the first frequency F1), and includes a signal generating unit 311 and a first phase shifter 312. The signal source 32 is a signal source that generates the second frequency F2 signal (fundamental wave signal having the second frequency F2), and includes a signal generating unit 321 and a second phase shifter 322. For each of the signal generating unit 211, the signal generating unit 221, the signal generating unit 311, and the signal generating unit 321, for example, a digital analog converter (DAC) or a direct digital synthesize (DDS) is used.

The signal source 21 and the signal source 31 operate in synchronization under control of a control unit (not illustrated), and a relationship in an amplitude and a phase between the first frequency F1 signal generated by the signal source 21 and the first frequency F1 signal generated by the signal source 31 is controlled. Similarly for the signal source 22 and the signal source 32, the signal source 22 and the signal source 32 operate in synchronization, and a relationship in an amplitude and a phase between the second frequency F2 signal generated by the signal source 22 and the second frequency F2 signal generated by the signal source 32 is controlled.

Note that FIG. 1 illustrates a case where the signal source 21 includes the signal generating unit 211 and the first phase shifter 212, the signal source 22 includes the signal generating unit 221 and the second phase shifter 222, the signal source 31 includes the signal generating unit 311 and the first phase shifter 312, and the signal source 32 includes the signal generating unit 321 and the second phase shifter 322, but it is not limited thereto. For example, each of the signal source 21, the signal source 22, the signal source 31, and the signal source 32 may be a digital-to-analog converter such as a radio frequency digital to analog converter (RFDAC).

In the first signal source 2, an output terminal of the first input combiner 23 is connected to an input terminal of the first amplifier 4, and a signal obtained by combining an output signal of the signal source 21 and an output signal of the signal source 22 is output to the first amplifier 4. As the first input combiner 23, for example, a Wilkinson combiner is used. Note that the first input combiner 23 is not limited to an in-phase combiner, and may be a 90 degree hybrid combiner for different phase combination. In a case where the first input combiner 23 is the combiner, adjustment of different phases in the combiner may be required in a signal path on an input side or the like.

The first amplifier 4 amplifies a signal output from the first signal source 2. An output terminal of the first amplifier 4 is connected to an input terminal of the output combiner 6. For example, the first amplifier 4 includes a field effect transistor (FET), a heterojunction bipolar transistor (HBT), or a high electron mobility transistor (HEMT), and a circuit including an input/output matching circuit and a bias circuit for the FET, the HBT, or the HEMT.

In the second signal source 3, an output terminal of the second input combiner 33 is connected to an input terminal of the second amplifier 5, and a signal obtained by combining an output signal of the signal source 31 and an output signal of the signal source 32 is output to the second amplifier 5. As the second input combiner 33, for example, a Wilkinson combiner is used. Note that the second input combiner 33 is not limited to an in-phase combiner, and may be a 90 degree hybrid combiner for different phase combination. In a case where the second input combiner 33 is the combiner, adjustment of different phases in the combiner may be required in a signal path on an input side or the like.

The second amplifier 5 amplifies a signal output from the second signal source 3. An output terminal of the second amplifier 5 is connected to an input terminal of the output combiner 6. For example, the second amplifier 5 includes an FET, an HBT, or an HEMT, and a circuit including an input/output matching circuit and a bias circuit for the FET, the HBT, or the HEMT. Gate biases of the first amplifier 4 and the second amplifier 5 have the same class of operation, but the class of operation is not limited. For example, the first amplifier 4 and the second amplifier 5 are transistors under the same bias condition. In addition, the first amplifier 4 and the second amplifier 5 may be transistors having the same size.

Note that it is assumed that the first amplifier 4 and the second amplifier 5 have the same electrical characteristics (output resistance and amplitude).

The output combiner 6 is a combiner that combines a signal amplified by the first amplifier 4 and a signal amplified by the second amplifier 5. One of two input terminals included in the output combiner 6 is connected to the output terminal of the first amplifier 4, the other is connected to the output terminal of the second amplifier 5, and an output terminal of the output combiner 6 is connected to the output terminal 7. As the output combiner 6, for example, a Wilkinson combiner or a 90 degree hybrid combiner is used. Note that the output combiner 6 is not limited to an in-phase combiner, and may be a 90 degree hybrid combiner or the like for different phase combination. In a case where the output combiner 6 is the combiner, adjustment of different phases in the combiner may be required in a signal path on an input side or the like.

The low distortion amplifier 1 is a so-called two-combining amplifier in which the output combiner 6 vector-combines a signal output from the first amplifier 4 and a signal output from the second amplifier 5 for each frequency, and outputs the resultant. Each of the signal output from the first amplifier 4 and the signal output from the second amplifier 5 includes an intermodulation distortion component having a frequency lower than the first frequency F1 and the second frequency F2 and an intermodulation distortion component having a frequency higher than the first frequency F1 and the second frequency F2 in addition to the first frequency F1 signal and the second frequency F2 signal which are fundamental wave signals.

The low distortion amplifier 1 can switch an operation mode in which an intermodulation distortion component is cancelled by controlling a relationship between $\Delta\theta_{F1}$ which is an angular difference in phase (hereinafter, simply referred to as a "phase difference") between the first frequency F1 signal input to the first amplifier 4 and the first frequency F1 signal input to the second amplifier 5 and a phase difference $\Delta\theta_{F2}$ between the second frequency F2 signal input to the first amplifier 4 and the second frequency F2 signal input to the second amplifier 5.

First, a first intermodulation distortion operation mode will be described in which a low-frequency intermodulation distortion component and a high-frequency intermodulation distortion component are cancelled by performing control in such a manner that the phase difference $\Delta\theta_{F1}$ between the first frequency F1 signals and the phase difference $\Delta\theta_{F2}$ between the second frequency F2 signals are symmetrical.

In the first intermodulation distortion canceling operation mode, control is performed in such a manner that the phase difference $\Delta\theta_{F1}$ between the first frequency F1 signals, the first frequency F1 being a center frequency, and the phase difference $\Delta\theta_{F2}$ between the second frequency F2 signals, the second frequency F2 being a center frequency, are symmetrical depending on a frequency band.

Note that the symmetry indicates a relationship in which the magnitudes of the phase difference $\Delta\theta_{F1}$ and the phase difference $\Delta\theta_{F2}$ are within a range of values defined as being equal, and the phase difference $\Delta\theta_{F1}$ and the phase difference $\Delta\theta_{F2}$ have opposite polarities.

In the first intermodulation distortion operation mode, the phase difference $\Delta\theta_{F1}$ between the first frequency F1 signals satisfies the following equation (1), and the phase difference $\Delta\theta_{F2}$ between the second frequency F2 signals satisfies the following equation (2). In the following equations (1) and (2), $X_{IM}$ represents the order of an intermodulation distortion component. The following equation (1) is a relational equation indicating the phase difference $\Delta\theta_{F1}$ necessary for canceling an intermodulation distortion component depending on the order of the intermodulation distortion component, and the following equation (2) is a relational equation indicating the phase difference $\Delta\theta_{F2}$ necessary for canceling an intermodulation distortion component depending on the order of the intermodulation distortion component.

$$+\text{-}180/X_{IM} = \Delta\theta_{F1} \qquad (1)$$

$$-\text{+}180/X_{IM} = \Delta\theta_{F2} \qquad (2)$$

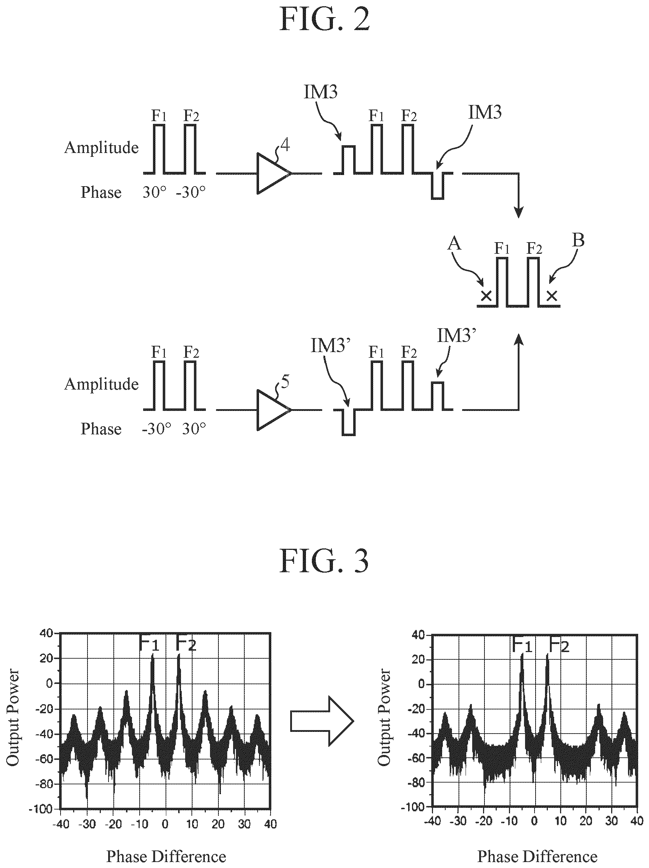

FIG. 2 is a schematic diagram illustrating an outline of intermodulation distortion compensation in the first intermodulation distortion canceling operation mode. FIG. 3 is a graph illustrating a change in an output power waveform of the output combiner 6 in the first intermodulation distortion canceling operation mode. In FIG. 3, a graph on a left of an arrow indicates output power of the low distortion amplifier 1 before operation in the first intermodulation distortion canceling operation mode, and a graph on a right of the arrow indicates output power of the low distortion amplifier 1 operated in the first intermodulation distortion canceling operation mode.

The low distortion amplifier 1 controls the phase difference $\Delta\theta_{F1}$ and the phase difference $\Delta\theta_{F2}$ between the first amplifier 4 and the second amplifier 5 in a symmetrical relationship depending on a frequency band. That is, the low distortion amplifier 1 performs control in such a manner that a relative relationship between the phase differences (the phase difference $\Delta\theta_{F1}$ and the phase difference $\Delta\theta_{F2}$) of input power depending on a frequency is symmetrical, whereby the operation mode is switched to the first intermodulation distortion canceling operation mode. At this time, an output power waveform of the output combiner 6 is switched from the graph on the left of the arrow to the graph on the right of the arrow.

For example, as illustrated in an upper portion of FIG. 2, in the first signal source 2, the first phase shifter 212 sets an angle of a phase of the first frequency F1 signal generated by the signal generating unit 211 to 30 degrees. The second phase shifter 222 sets an angle of a phase of the second frequency F2 signal generated by the signal generating unit 221 to -30 degrees. These signals are combined by the first input combiner 23 and amplified by the first amplifier 4.

Furthermore, as illustrated in a lower portion of FIG. 2, in the second signal source 3, the first phase shifter 312 sets an angle of a phase of the first frequency F1 signal generated by the signal generating unit 311 to -30 degrees, and the second phase shifter 322 sets an angle of a phase of the second frequency F2 signal generated by the signal generating unit 321 to 30 degrees. These signals are combined by the second input combiner 33 and amplified by the second amplifier 5.

The output combiner 6 combines a signal output from the first amplifier 4 and a signal output from the second amplifier 5. In the combined signal, the phase difference $\Delta\theta_{F1}$ is 30 - (-30) = 60 degrees obtained by subtracting -30 degrees that is the phase of the first frequency F1 signal input to the second amplifier 5 from 30 degrees that is the phase of the first frequency F1 signal input to the first amplifier 4.

In addition, the phase difference $\Delta\theta_{F2}$ is -30 - (30) = -60 degrees obtained by subtracting 30 degrees that is the phase of the second frequency F2 signal input to the second amplifier 5 from -30 degrees that is the phase of the second frequency F2 signal input to the first amplifier 4.

Since the phase difference $\Delta\theta_{F1}$ is 60 degrees and the phase difference $\Delta\theta_{F2}$ is -60 degrees, the phase difference $\Delta\theta_{F1}$ and the phase difference $\Delta\theta_{F2}$ are symmetrical. In addition, it is assumed that an amplitude of a signal generated by the first signal source 2 and an amplitude of a signal generated by the second signal source 3 are within a range of values defined to be equal.

Here, an RF component of each signal can be expressed by an equation of $A \times \cos(\omega t + \theta)$. Note that A represents an amplitude, t represents time, and θ represents a phase. In the following description, a phase value is represented on the basis of t = 0. The first amplifier 4 receives a signal having a phase of 30 degrees of the first frequency F1 signal and a phase of -30 degrees of the second frequency F2 signal, and amplifies the input signal. At this time, as illustrated in FIG. 2, due to nonlinearity of the first amplifier 4, in an output signal of the first amplifier 4, a third-order intermodulation distortion is generated, and a low-frequency intermodulation distortion component IM3 having a phase of 90 degrees and a high-frequency intermodulation distortion component IM3 having a phase of -90 degrees are included.

Meanwhile, the second amplifier 5 receives a signal having a phase of -30 degrees of the first frequency F1 signal and a phase of 30 degrees of the second frequency F2 signal. Since the phase difference $\Delta\theta_{F1}$ between the first frequency F1 signal of the first amplifier 4 and the first frequency F1 signal of the second amplifier 5 is 60 degrees and the phase difference $\Delta\theta_{F2}$ between the second frequency F2 signal of the first amplifier 4 and the second frequency F2 signal of the second amplifier 5 is -60 degrees, the phase difference $\Delta\theta_{F1}$ and the phase difference $\Delta\theta_{F2}$ are symmetrical.

Note that the magnitudes of the phase differences for the first frequency F1 and the second frequency F2 satisfy the above equations (1) and (2), the order $X_{IM}$ of the intermodulation distortion is 3, and a sign described first is selected from the signs of 180 degrees (for example, in a case of +-180, + 180 is selected.). The second amplifier 5 amplifies an input signal from the second signal source 3. At this time, as illustrated in FIG. 2, due to nonlinearity of the second amplifier 5, in an output signal of the second amplifier 5, a third-order intermodulation distortion is generated, and a low-frequency intermodulation distortion component IM3' having a phase of -90 degrees and a high-frequency intermodulation distortion component IM3' having a phase of 90 degrees are included.

As for the third-order intermodulation distortion components IM3 and IM3', the output combiner 6 vector-combines the signal output from the first amplifier 4 and the signal output from the second amplifier 5, whereby a phase difference between the low-frequency intermodulation distortion components is 90 degrees - (-90 degrees) = 180 degrees, and combining is performed in opposite phases. As a result, as indicated by an arrow A in FIG. 2, the low-frequency third-order intermodulation distortion is suppressed. Similarly, a phase difference between the high-frequency intermodulation distortion components is -90 degrees - (90 degrees) = -180 degrees, and combining is performed in opposite phases. As a result, as indicated by an arrow B in FIG. 2, the high-frequency third-order intermodulation distortion is also suppressed.

Note that, in the above description, the first phase shifter 212 sets the angle of the phase of the first frequency F1 signal to 30 degrees, and the first phase shifter 312 sets the angle of the phase of the first frequency F1 signal to -30 degrees. However, the low distortion amplifier 1 is not limited to these phases. That is, in a case where the third-order intermodulation distortion is generated, the phase difference $\Delta\theta_{F1}$ between the first frequency F1 signals only needs to be 60 degrees.

For example, a case where the phase of the first frequency F1 signal input to the first amplifier 4 is set to 60 degrees and the phase of the first frequency F1 signal input to the second amplifier 5 is set to 0 degrees, a case where the phase of the first frequency F1 signal input to the first amplifier 4 is set to 80 degrees and the phase of the first frequency F1 signal input to the second amplifier 5 is set to 20 degrees, or a case where the phase of the first frequency F1 signal input to the first amplifier 4 is set to 70 degrees and the phase of the first frequency F1 signal input to the second amplifier 5 is set to 10 degrees may be adopted.

In addition, in the above description, the second phase shifter 222 sets the angle of the phase of the second frequency F2 signal to -30 degrees, and second phase shifter 322 sets the angle of the phase of the second frequency F2 signal to 30 degrees. However, low distortion amplifier 1 is not limited to these phases. That is, in a case where the third-order intermodulation distortion is generated, the phase difference $\Delta\theta_{F2}$ between the second frequency F2 signals only needs to be -60 degrees.

For example, a case where the phase of the second frequency F2 signal input to the first amplifier 4 is 0 degrees and the phase of the second frequency F2 signal input to the second amplifier 5 is 60 degrees, a case where the phase of the second frequency F2 signal input to the first amplifier 4 is 20 degrees and the phase of the second frequency F2 signal input to the second amplifier 5 is 80 degrees, or a case where the phase of the second frequency F2 signal input to the first amplifier 4 is 10 degrees and the phase of the second frequency F2 signal input to the second amplifier 5 is 70 degrees may be adopted.

In addition, the low distortion amplifier 1 allows an error of about 8% in phase.

A fundamental wave signal included in the signal output from the first amplifier 4 and a fundamental wave signal included in the signal output from the second amplifier 5 are vector-combined by the output combiner 6. At this time, combining is performed in such a manner that a phase difference between the fundamental wave signal having the first frequency F1 output from the first amplifier 4 and the fundamental wave signal having the first frequency F1 output from the second amplifier 5 is 60 degrees. Furthermore, combining is performed in such a manner that a phase difference between the fundamental wave signal having the second frequency F2 output from the first amplifier 4 and the fundamental wave signal having the second frequency F2 output from the second amplifier 5 is -60 degrees.

By combining of the input signals by the output combiner 6, a low-frequency intermodulation distortion component and a high-frequency intermodulation distortion component are completely suppressed in an output signal of the output combiner 6, whereas an amplitude of the fundamental wave signal is about 87% of an amplitude of the input signal, and a power reduction amount of the fundamental wave signal with respect to the suppression amount of the intermodulation distortion is practically sufficient.

Next, another example of the first intermodulation distortion canceling operation mode will be described.

In the operation mode, control is performed in such a manner that an absolute value of the phase difference $\Delta\theta_{F1}$ between the first frequency F1 signals, the first frequency F1 being a center frequency, and an absolute value of the phase difference $\Delta\theta_{F2}$ between the second frequency F2 signals, the second frequency F2 being a center frequency, are equal to each other, and polarities thereof are opposite to each other depending on a frequency band.

For example, the phase difference $\Delta\theta_{F1}$ between the first frequency F1 signal of the first amplifier 4 and the first frequency F1 signal of the second amplifier 5 is set to 60 degrees, the phase difference $\Delta\theta_{F2}$ between the second frequency F2 signal of the first amplifier 4 and the second frequency F2 signal of the second amplifier 5 is set to - 60 degrees, and control is performed in such a manner that the phase difference $\Delta\theta_{F1}$ and the phase difference $\Delta\theta_{F2}$ are symmetrical depending on a frequency band, whereby a relative relationship between amplitudes of third-order harmonics is controlled.

Furthermore, in the operation mode, control is performed in such a manner that the absolute value of the phase difference $\Delta\theta_{F1}$ and the absolute value of the phase difference $\Delta\theta_{F2}$ are equal to each other and polarities thereof are opposite to each other. For example, the first amplifier 4 receives a signal in which the phase of the first frequency F1 signal is -30 degrees and the phase of the second frequency F2 signal is 30 degrees. As a result, in an output signal of the first amplifier 4, a third-order intermodulation distortion is generated due to nonlinearity of amplification, and a low-frequency third-order intermodulation distortion component having a phase of -90 degrees and a high-frequency third-order intermodulation distortion component having a phase of 90 degrees are included.

Meanwhile, the second amplifier 5 receives a signal having a phase of 30 degrees of the first frequency F1 signal and a phase of -30 degrees of the second frequency F2 signal. As a result, the phase difference $\Delta\theta_{F1}$ between the first frequency F1 signal of the first amplifier 4 and the first frequency F1 signal of the second amplifier 5 is -60 degrees, the phase difference $\Delta\theta_{F2}$ between the second frequency F2 signal of the first amplifier 4 and the second frequency F2 signal of the second amplifier 5 is 60 degrees, and the phase difference $\Delta\theta_{F1}$ and the phase difference $\Delta\theta_{F2}$ are symmetrical.

Note that the magnitudes of the phase differences for the first frequency F1 signal and the second frequency F2 signal satisfy the above equations (1) and (2), the order $X_{IM}$ of the intermodulation distortion is 3, and a sign described later is selected from the signs of 180 degrees (for example, in a case of +-180, -180 is selected.). The second amplifier 5 amplifies an input signal from the second signal source 3. At this time, due to nonlinearity of the second amplifier 5, in an output signal of the second amplifier 5, a third-order intermodulation distortion is generated, and a low-frequency intermodulation distortion component having a phase of 90 degrees and a high-frequency intermodulation distortion component having a phase of -90 degrees are included.

As for the third-order intermodulation distortion component, the output combiner 6 vector-combines the signal output from the first amplifier 4 and the signal output from the second amplifier 5, whereby a phase difference between the low-frequency intermodulation distortion components is -90 degrees - (90 degrees) = -180 degrees, and combining is performed in opposite phases. As a result, the low-frequency third-order intermodulation distortion is suppressed. Similarly, a phase difference between the high-frequency intermodulation distortion components is 90 degrees - (-90 degrees) = 180 degrees, and combining is performed in opposite phases. As a result, the high-frequency third-order intermodulation distortion is also suppressed.

Note that, in the above description, the first phase shifter 212 sets the angle of the phase of the first frequency F1 signal to -30 degrees, and the first phase shifter 312 sets the angle of the phase of the first frequency F1 signal to 30 degrees. However, the low distortion amplifier 1 is not limited to these phases. That is, in a case where the third-order intermodulation distortion is generated, the phase difference $\Delta\theta_{F1}$ between the first frequency F1 signals only needs to be -60 degrees.

For example, a case where the phase of the first frequency F1 signal input to the first amplifier 4 is 0 degrees and the phase of the first frequency F1 signal input to the second amplifier 5 is 60 degrees, a case where the phase of the first frequency F1 signal input to the first amplifier 4 is 20 degrees and the phase of the first frequency F1 signal input to the second amplifier 5 is 80 degrees, or a case where the phase of the first frequency F1 signal input to the first amplifier 4 is 10 degrees and the phase of the first frequency F1 signal input to the second amplifier 5 is 70 degrees may be adopted.

In addition, in the above description, the second phase shifter 222 sets the angle of the phase of the second frequency F2 signal to 30 degrees, and second phase shifter 322 sets the angle of the phase of the second frequency F2 signal to -30 degrees. However, low distortion amplifier 1 is not limited to these phases. That is, in a case where the third-order intermodulation distortion is generated, the phase difference $\Delta\theta_{F2}$ between the second frequency F2 signals only needs to be 60 degrees.

For example, a case where the phase of the second frequency F2 signal input to the first amplifier 4 is 60 degrees and the phase of the second frequency F2 signal input to the second amplifier 5 is 0 degrees, a case where the phase of the second frequency F2 signal input to the first amplifier 4 is 80 degrees and the phase of the second frequency F2 signal input to the second amplifier 5 is 20 degrees, or a case where the phase of the second frequency F2 signal input to the first amplifier 4 is 70 degrees and the phase of the second frequency F2 signal input to the second amplifier 5 is 10 degrees may be adopted.

In addition, the low distortion amplifier 1 allows an error of about 8% in phase.

A fundamental wave signal included in the signal output from the first amplifier 4 and a fundamental wave signal included in the signal output from the second amplifier 5 are vector-combined by the output combiner 6. At this time, combining is performed in such a manner that a phase difference between the fundamental wave signal having the first frequency F1 output from the first amplifier 4 and the fundamental wave signal having the first frequency F1 output from the second amplifier 5 is -60 degrees. Furthermore, combining is performed in such a manner that a phase difference between the fundamental wave signal having the second frequency F2 output from the first amplifier 4 and the fundamental wave signal having the second frequency F2 output from the second amplifier 5 is 60 degrees.

By combining of the input signals by the output combiner 6, a low-frequency intermodulation distortion component and a high-frequency intermodulation distortion component are completely suppressed in an output signal of the output combiner 6, whereas an amplitude of the fundamental wave signal is about 87% of an amplitude of the input signal, and a power reduction amount of the fundamental wave signal with respect to the suppression amount of the intermodulation distortion is practically sufficient.

In the first intermodulation distortion canceling operation mode, the phase difference $\Delta\theta_{F1}$ between the first frequency F1 signal of the first amplifier 4 and the first frequency F1 signal of the second amplifier 5 is +-60 degrees, and the phase difference $\Delta\theta_{F2}$ between the second frequency signal F2 of the first amplifier 4 and the second frequency signal of the second amplifier 5 is -+60 degrees depending on a frequency band, the magnitudes of $\Delta\theta_{F1}$ and $\Delta\theta_{F2}$ satisfy the above equations (1) and (2), and $X_{IM}$ is 3.

Similarly, also in any intermodulation distortion canceling operation mode other than the third order, control is performed in such a manner that the magnitude of the phase difference $\Delta\theta_{F1}$ between the first frequency F1 signal of the first amplifier 4 and the first frequency F1 signal of the second amplifier 5 and the magnitude of the phase difference $\Delta\theta_{F2}$ between the second frequency signal F2 of the first amplifier 4 and the second frequency signal of the second amplifier 5 satisfy the above equations (1) and (2), and the phase difference $\Delta\theta_{F1}$ and the phase difference $\Delta\theta_{F2}$ are symmetrical, whereby the intermodulation distortion is canceled.

For example, in the first intermodulation distortion canceling operation mode, in a case where a fifth-order intermodulation distortion component is canceled, control is performed in such a manner that the magnitude of the phase difference $\Delta\theta_{F1}$ between the first frequency F1 signal of the first amplifier 4 and the first frequency F1 signal of the second amplifier 5 and the magnitude of the phase difference $\Delta\theta_{F2}$ between the second frequency F2 signal of the first amplifier 4 and the second frequency F2 signal of the second amplifier 5 are each 26 degrees and satisfy the above equations (1) and (2), $X_{IM}$ is 5, and the phase difference $\Delta\theta_{F1}$ and the phase difference $\Delta\theta_{F2}$ are symmetrical, whereby a relative relationship between amplitudes of fifth-order harmonics can be controlled. As described above, the low distortion amplifier 1 can suppress an intermodulation distortion while suppressing deterioration of a fundamental wave signal by performing control in such a manner that the phase difference $\Delta\theta_{F1}$ and the phase difference $\Delta\theta_{F2}$ are symmetrical.

Next, a second intermodulation distortion canceling operation mode will be described.

In the second intermodulation distortion canceling operation mode, since the phase difference $\Delta\theta_{F1}$ and the phase difference $\Delta\theta_{F2}$ are not symmetrical, the degree of freedom for band selection is high, and it is possible to cancel intermodulation distortions of any different orders for a low-frequency intermodulation distortion and a high-frequency intermodulation distortion.

The following equation (3) represents the phase difference $\Delta\theta_{F1}$ between the low-frequency first frequency F1 signal of the first amplifier 4 and the low-frequency first frequency F1 signal of the second amplifier 5, and the following equation (4) represents the phase difference $\Delta\theta_{F2}$ between the high-frequency second frequency F2 signal of the first amplifier 4 and the high-frequency second frequency F2 signal of the second amplifier 5. In the following equations (3) and (4), $Y_{IML}$ represents the order of a low-frequency intermodulation distortion component. $Z_{IMH}$ represents the order of a high-frequency intermodulation distortion component.

$$(2 - (Y_{IML} - Z_{IMH}))/Y_{IML} + Z_{IMH}) \times +\text{-}180 = \Delta\theta_{F1} \qquad (3)$$

$$(2 + (Y_{IML} - Z_{IMH}))/Y_{IML} + Z_{IMH}) \times -\text{+}180 = \Delta\theta_{F2} \qquad (4)$$

The low distortion amplifier 1 performs control in such a manner that the magnitude of the phase difference $\Delta\theta_{F1}$ between the first frequency F1 signals satisfies the above equation (3) and the magnitude of the phase difference $\Delta\theta_{F2}$ between the second frequency F2 signals satisfies the above equation (4) depending on a frequency band, whereby the first intermodulation distortion canceling operation mode is switched to the second intermodulation distortion operation mode, and it is possible to cancel intermodulation distortions of any different orders.

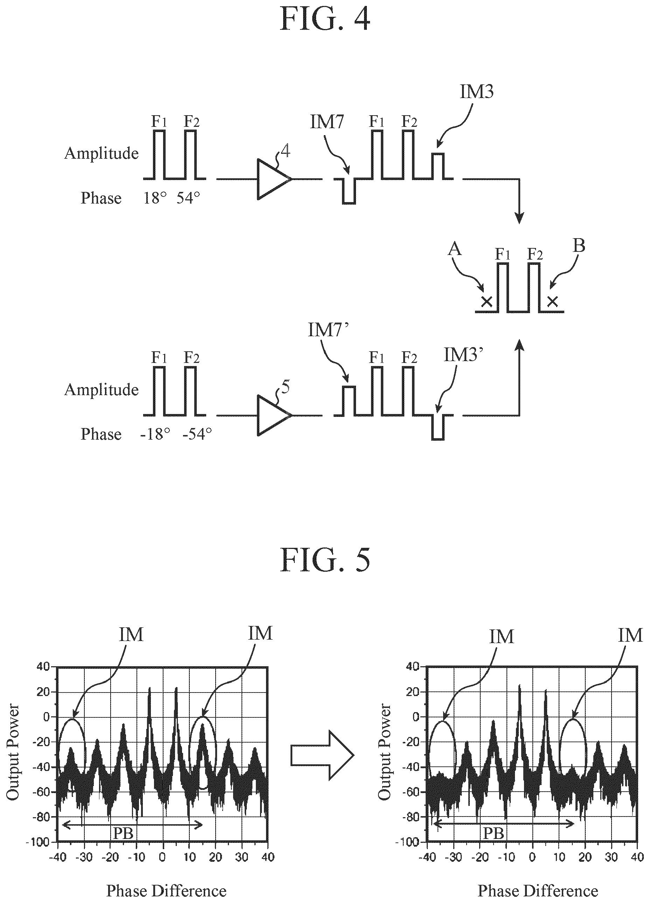

FIG. 4 is a schematic diagram illustrating an outline of intermodulation distortion compensation in the second intermodulation distortion canceling operation mode. FIG. 5 is a graph illustrating a change in an output power waveform of the output combiner 6 in the second intermodulation distortion canceling operation mode. In FIG. 5, a graph on a left of an arrow indicates output power of the low distortion amplifier 1 before operation in the second intermodulation distortion canceling operation mode, and a graph on a right of the arrow indicates output power of the low distortion amplifier 1 operated in the second intermodulation distortion canceling operation mode. FIGS. 4 and 5 illustrate a case where, for example, an intermodulation distortion component IM3 which is a high-frequency third-order harmonic and an intermodulation distortion component IM7 which is a low-frequency seventh-order harmonic are canceled in the second intermodulation distortion canceling operation mode.

For example, in FIG. 5, PB represents a pass band of a filter, and IM represents an intermodulation distortion generated around a cutoff frequency band of the filter. The low distortion amplifier 1 removes the intermodulation distortion depending on a cutoff frequency of the filter. Furthermore, the low distortion amplifier 1 performs control in such a manner that the magnitudes of the phase differences (the phase difference $\Delta\theta_{F1}$ and the phase difference $\Delta\theta_{F2}$) of input power depending on a frequency satisfy the above equations (3) and (4), whereby the operation mode is switched to the second intermodulation distortion canceling operation mode. At this time, an output power waveform of the output combiner 6 is switched from the graph on the left of the arrow to the graph on the right of the arrow.

In addition, as illustrated in an upper portion of FIG. 4, in the first signal source 2, the first phase shifter 212 sets an angle of a phase of the first frequency F1 signal generated by the signal generating unit 211 to 18 degrees. The second phase shifter 222 sets an angle of a phase of the second frequency F2 signal generated by the signal generating unit 221 to 54 degrees. These signals are combined by the first input combiner 23 and amplified by the first amplifier 4.

Furthermore, as illustrated in a lower portion of FIG. 4, in the second signal source 3, the first phase shifter 312 sets an angle of a phase of the first frequency F1 signal generated by the signal generating unit 311 to -18 degrees, and the second phase shifter 322 sets an angle of a phase of the second frequency F2 signal generated by the signal generating unit 321 to -54 degrees. These signals are combined by the second input combiner 33 and amplified by the second amplifier 5.

The output combiner 6 combines a signal output from the first amplifier 4 and a signal output from the second amplifier 5. In the combined signal, the phase difference $\Delta\theta_{F1}$ is 18 - (-18) = 36 degrees obtained by subtracting -18 degrees that is a phase of the first frequency F1 signal output from the second signal source 3 from 18 degrees that is a phase of the first frequency F1 signal output from the first signal source 2.

In addition, the phase difference $\Delta\theta_{F2}$ is 54 - (-54) = 108 degrees obtained by subtracting -54 degrees that is a phase of the second frequency F2 signal output from the second signal source 3 from 54 degrees that is a phase of the second frequency F2 signal output from the first signal source 2.

Since the phase difference $\Delta\theta_{F1}$ is 36 degrees and the phase difference $\Delta\theta_{F2}$ is 108 degrees, the phase difference $\Delta\theta_{F1}$ and the phase difference $\Delta\theta_{F2}$ satisfy the above equations (3) and (4).

Note that it is assumed that an amplitude of a signal output from the first signal source 2 and an amplitude of a signal output from the second signal source 3 are within a range of values defined to be equal.

Next, a case where third-order and seventh-order intermodulation distortions are canceled in the second intermodulation distortion canceling operation mode will be described. The first amplifier 4 receives a combined signal having a phase of 18 degrees of the first frequency F1 signal and a phase of 54 degrees of the second frequency F2 signal, and amplifies the input signal. At this time, due to nonlinearity of the first amplifier 4, a third-order intermodulation distortion and a seventh-order intermodulation distortion are generated in an output signal of the first amplifier 4. As a result, as illustrated in FIG. 4, in the output signal of the first amplifier 4, a low-frequency third-order intermodulation distortion component having a phase of -18 degrees and a high-frequency third-order intermodulation distortion component having a phase of 90 degrees are included as a third-order intermodulation distortion component IM3, and a low-frequency seventh-order intermodulation distortion component having a phase of -90 degrees and a high-frequency seventh-order intermodulation distortion component having a phase of 162 degrees are included as a seventh-order intermodulation distortion component IM7.

Meanwhile, the second amplifier 5 receives a signal having a phase of -18 degrees of the first frequency F1 signal and a phase of -54 degrees of the second frequency F2 signal. The phase difference $\Delta\theta_{F1}$ between the first frequency F1 signal of the first amplifier 4 and the first frequency F1 signal of the second amplifier 5 is 36 degrees, and the phase difference $\Delta\theta_{F2}$ between the second frequency F2 signal of the first amplifier 4 and the second frequency F2 signal of the second amplifier 5 is 108 degrees.

Note that the magnitudes of the phase differences for the first frequency F1 and the second frequency F2 satisfy the above equations (3) and (4), the order $Y_{IML}$ of the low-frequency intermodulation distortion is 7, the order $Z_{IMH}$ of the high-frequency intermodulation distortion is 3, and a sign described later is selected from the signs of 180 degrees (for example, in a case of +-180, -180 is selected.). Since the above equations (3) and (4) include the above equations (1) and (2), the relationship between the phase difference $\Delta\theta_{F1}$ and the phase difference $\Delta\theta_{F2}$ is more generally controlled than in the first intermodulation distortion canceling operation mode.

The second amplifier 5 amplifies an input signal from the second signal source 3. At this time, due to nonlinearity of the second amplifier 5, a third-order intermodulation distortion and a seventh-order intermodulation distortion are generated in an output signal of the second amplifier 5. As a result, in the output signal of the second amplifier 5, a low-frequency third-order intermodulation distortion component having a phase of 18 degrees and a high-frequency third-order intermodulation distortion component having a phase of -90 degrees are included as a third-order intermodulation distortion component IM3', and a low-frequency seventh-order intermodulation distortion component having a phase of 90 degrees and a high-frequency seventh-order intermodulation distortion component having a phase of -162 degrees are included as a seventh-order intermodulation distortion component IM7'.

The output combiner 6 vector-combines the signal output from the first amplifier 4 and the signal output from the second amplifier 5, whereby combining is performed in such a manner that a phase difference between the low-frequency third-order intermodulation distortion components is -18 degrees - (18 degrees) = -36 degrees. As a result, the low-frequency third-order intermodulation distortion component is not suppressed. Meanwhile, a phase difference between the high-frequency third-order intermodulation distortion components is 90 degrees - (-90 degrees) = 180 degrees, and combining is performed in opposite phases. As a result, as indicated by an arrow B in FIG. 4, the high-frequency third-order intermodulation distortion is suppressed.

Similarly, combining is performed in such a manner that a phase difference between the high-frequency seventh-order intermodulation distortion components is 162 degrees - (-162 degrees) = 324 degrees. As a result, the high-frequency seventh-order intermodulation distortion component is not suppressed. Meanwhile, a phase difference between the low-frequency seventh-order intermodulation distortion components is -90 degrees - (90 degrees) = -180 degrees, and combining is performed in opposite phases. As a result, as indicated by an arrow A in FIG. 4, the low-frequency seventh-order intermodulation distortion is suppressed.

Note that, in the above description, the first phase shifter 212 sets the angle of the phase of the first frequency F1 signal to 18 degrees, and the first phase shifter 312 sets the angle of the phase of the first frequency F1 signal to -18 degrees. However, the low distortion amplifier 1 is not limited to these phases. That is, in a case where the intermodulation distortion is generated, the phase difference $\Delta\theta_{F1}$ between the first frequency F1 signals only needs to be 36 degrees. For example, the phase of the first frequency F1 signal input to the first amplifier 4 may be set to 36 degrees, and the phase of the first frequency F1 signal input to the second amplifier 5 may be set to 0 degrees.

In addition, in the above description, the second phase shifter 222 sets the angle of the phase of the second frequency F2 signal to 54 degrees, and second phase shifter 322 sets the angle of the phase of the second frequency F2 signal to -54 degrees. However, low distortion amplifier 1 is not limited to these phases. That is, in a case where the intermodulation distortion is generated, the phase difference $\Delta\theta_{F2}$ between the second frequency F2 signals only needs to be 108 degrees. For example, the phase of the second frequency F2 signal input to the first amplifier 4 may be set to 108 degrees, and the phase of the second frequency F2 signal input to the second amplifier 5 may be set to 0 degrees.

The output combiner 6 vector-combines the input signals, whereby the phase difference $\Delta\theta_{F1}$ between the fundamental wave signal having the first frequency F1 of the first amplifier 4 and the fundamental wave signal having the first frequency F1 of the second amplifier 5 is combined at 36 degrees, and the phase difference $\Delta\theta_{F2}$ between the fundamental wave signal having the second frequency F2 of the first amplifier 4 and the fundamental wave signal having the second frequency F2 of the second amplifier 5 is combined at 108 degrees. As a result, the low-frequency seventh-order intermodulation distortion and the high-frequency third-order intermodulation distortion are completely suppressed, whereas a power reduction amount of the fundamental wave signal is practically sufficient.

By performing control in such a manner that the magnitudes of the phase difference $\Delta\theta_{F1}$ and the phase difference $\Delta\theta_{F2}$ satisfy the above equations (3) and (4), the low distortion amplifier 1 can cancel any different intermodulation distortions other than the low-frequency third-order harmonic and the high-frequency seventh harmonic.

For example, by performing control in such a manner that the magnitudes of the phase difference $\Delta\theta_{F1}$ and the phase difference $\Delta\theta_{F2}$ satisfy the above equations (3) and (4), $Y_{IML}$ is 5, and $Z_{IMH}$ is 7, the low distortion amplifier 1 can control a relative relationship between an amplitude of a fifth-order harmonic and an amplitude of a seventh-order harmonic, and can cancel the low-frequency fifth-order harmonic and the high-frequency seventh-order harmonic. In a case where the low-frequency fifth-order harmonic and the high-frequency seventh-order harmonic are cancelled, control is performed in such a manner that the phase difference $\Delta\theta_{F1}$ and the phase difference $\Delta\theta_{F2}$ satisfy the above equations (3) and (4) by setting the phase difference $\Delta\theta_{F1}$ to 60 degrees and setting the phase difference $\Delta\theta_{F2}$ to 0 degrees, $Y_{IML}$ is 5, and $Z_{IMH}$ is 7, whereby a relative relationship between an amplitude of the fifth-order harmonic and an amplitude of the seventh-order harmonic can be controlled.

Since intermodulation distortions of different orders can be cancelled in the second intermodulation distortion canceling operation mode, for example, as illustrated in FIG. 5, intermodulation distortions in a cutoff band of a filter can be canceled. As a result, a frequency band in which a distortion is compensated can be enlarged without enlarging a pass band of the filter, and the wideband low distortion amplifier 1 is achieved. In addition, as in the first intermodulation distortion canceling operation mode, the low distortion amplifier 1 operating in the second intermodulation distortion canceling operation mode can perform distortion compensation in which a ratio at which the intermodulation distortion component is suppressed is larger than a ratio at which the fundamental wave signal is deteriorated.

Next, a third intermodulation distortion canceling operation mode will be described.

In the third intermodulation distortion canceling operation mode, as in the second intermodulation distortion canceling operation mode, since the phase difference $\Delta\theta_{F1}$ and the phase difference $\Delta\theta_{F2}$ are not symmetrical, the degree of freedom for band selection is high, and it is possible to cancel intermodulation distortions of any different orders for a low-frequency intermodulation distortion or a high-frequency intermodulation distortion. That is, in the third intermodulation distortion canceling operation mode, it is possible to cancel only one of the low-frequency intermodulation distortion and the high-frequency intermodulation distortion.

The following equation (5) represents a relationship between the phase difference $\Delta\theta_{F1}$ between the first frequency F1 signal of the first amplifier 4 and the first frequency F1 signal of the second amplifier 5, and the phase difference $\Delta\theta_{F2}$ between the second frequency F2 signal of the first amplifier 4 and the second frequency F2 signal of the second amplifier 5 in the high-frequency intermodulation distortion. The following equation (6) represents a relationship between the phase difference $\Delta\theta_{F1}$ between the first frequency F1 signal of the first amplifier 4 and the first frequency F1 signal of the second amplifier 5, and the phase difference $\Delta\theta_{F2}$ between the second frequency F2 signal of the first amplifier 4 and the second frequency F2 signal of the second amplifier 5 in the low-frequency intermodulation distortion. In the following equations (5) and (6), n and m are integers. In addition, 2n + 1 = $Z_{IMH}$, and 2m + 1 = $Y_{IML}$.

$$(n + 1)\Delta\theta_{F2} - n\Delta\theta_{F1} = -+180 \qquad (5)$$

$$(m + 1)\Delta\theta_{F1} - m\Delta\theta_{F2} = +-180 \qquad (6)$$

The low distortion amplifier 1 performs control in such a manner that the magnitude of the phase difference $\Delta\theta_{F1}$ between the first frequency F1 signals and the magnitude of the phase difference $\Delta\theta_{F2}$ between the second frequency F2 signals satisfy the above equation (5) depending on a frequency band, whereby the operation mode is switched to the third intermodulation distortion operation mode. In the third intermodulation distortion operation mode, it is possible to cancel intermodulation distortion of any order and any band.

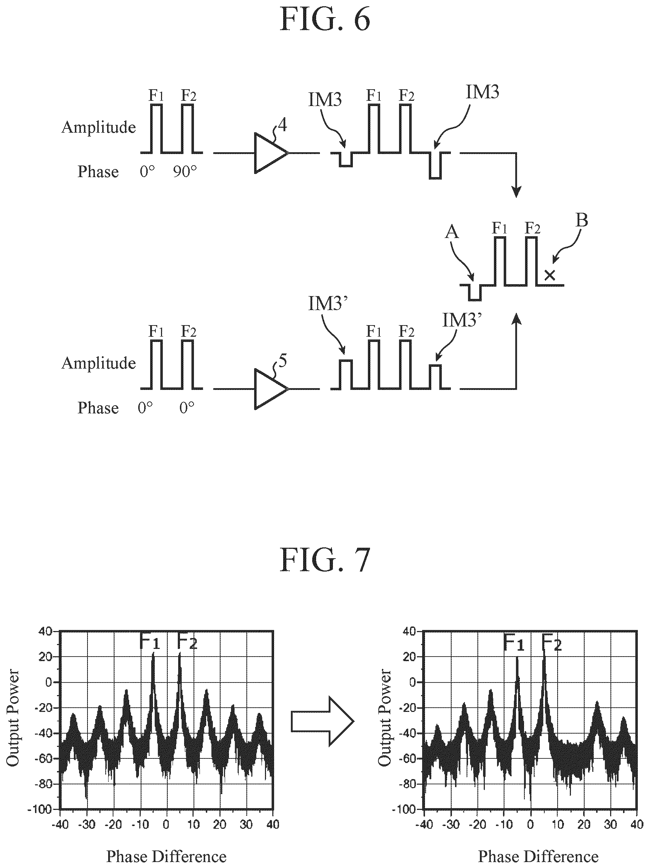

FIG. 6 is a schematic diagram illustrating an outline of intermodulation distortion compensation in the third intermodulation distortion canceling operation mode. FIG. 7 is a graph illustrating a change in an output power waveform of the output combiner 6 in the third intermodulation distortion canceling operation mode. In FIG. 7, a graph on a left of an arrow indicates output power of the low distortion amplifier 1 before operation in the third intermodulation distortion canceling operation mode, and a graph on a right of the arrow indicates output power of the low distortion amplifier 1 operated in the third intermodulation distortion canceling operation mode. FIGS. 6 and 7 illustrate a case where, for example, an intermodulation distortion component IM3 which is a high-frequency third-order harmonic is canceled in the third intermodulation distortion canceling operation mode.

For example, in FIG. 7, the low distortion amplifier 1 performs control in such a manner that the magnitudes of the phase differences (the phase difference $\Delta\theta_{F1}$ and the phase difference $\Delta\theta_{F2}$) of input power depending on a frequency satisfy the above equation (5), whereby the operation mode is switched to the third intermodulation distortion canceling operation mode. At this time, an output power waveform of the output combiner 6 is switched from the graph on the left of the arrow to the graph on the right of the arrow.

In a case where a high-frequency third-order harmonic is canceled, as illustrated in an upper portion of FIG. 6, in the first signal source 2, the first phase shifter 212 sets an angle of a phase of the first frequency F1 signal generated by the signal generating unit 211 to 0 degrees. The second phase shifter 222 sets an angle of a phase of the second frequency F2 signal generated by the signal generating unit 221 to 90 degrees. These signals are combined by the first input combiner 23 and amplified by the first amplifier 4.

Furthermore, as illustrated in a lower portion of FIG. 6, in the second signal source 3, the first phase shifter 312 sets an angle of a phase of the first frequency F1 signal generated by the signal generating unit 311 to 0 degrees, and the second phase shifter 322 sets an angle of a phase of the second frequency F2 signal generated by the signal generating unit 321 to 0 degrees. These signals are combined by the second input combiner 33 and amplified by the second amplifier 5.

The output combiner 6 combines a signal output from the first amplifier 4 and a signal output from the second amplifier 5. In the combined signal, the phase difference $\Delta\theta_{F1}$ is 0 - (0) = 0 degrees obtained by subtracting 0 degrees that is a phase of the first frequency F1 signal output from the second signal source 3 from 0 degrees that is a phase of the first frequency F1 signal output from the first signal source 2.

In addition, the phase difference $\Delta\theta_{F2}$ is 90 - 0 = 90 degrees obtained by subtracting 0 degrees that is a phase of the second frequency F2 signal output from the second signal source 3 from 90 degrees that is a phase of the second frequency F2 signal output from the first signal source 2. Since the phase difference $\Delta\theta_{F1}$ is 0 degrees and the phase difference $\Delta\theta_{F2}$ is 90 degrees, the phase difference $\Delta\theta_{F1}$ and the phase difference $\Delta\theta_{F2}$ satisfy the above equation (5).

Note that it is assumed that an amplitude of a signal generated by the first signal source 2 and an amplitude of a signal generated by the second signal source 3 are within a range of values defined to be equal.

Next, a case where a third-order intermodulation distortion is canceled in the third intermodulation distortion canceling operation mode will be described. The first amplifier 4 receives a signal having a phase of 0 degrees of the first frequency F1 signal and a phase of 90 degrees of the second frequency F2 signal, and amplifies the input signal. At this time, due to nonlinearity of the first amplifier 4, a third-order intermodulation distortion is generated in an output signal of the first amplifier 4. As a result, in the output signal of the first amplifier 4, as illustrated in FIG. 6, a low-frequency third-order intermodulation distortion component having a phase of -90 degrees and a high-frequency third-order intermodulation distortion component having a phase of 180 degrees are included as a third-order intermodulation distortion component IM3.

Meanwhile, the second amplifier 5 receives a signal having a phase of 0 degrees of the first frequency F1 signal and a phase of 0 degrees of the second frequency F2 signal. The phase difference $\Delta\theta_{F1}$ between the first frequency F1 signal of the first amplifier 4 and the first frequency F1 signal of the second amplifier 5 is 0 degrees, and the phase difference $\Delta\theta_{F2}$ between the second frequency F2 signal of the first amplifier 4 and the second frequency F2 signal of the second amplifier 5 is 90 degrees.

Note that the magnitudes of the phase differences for the first frequency F1 and the second frequency F2 satisfy the above equation (5), n is 1, and a sign of + is selected from the signs of 180 degrees (for example, in a case of +-180, + 180 is selected.). Since the above equations (5) and (6) include the above equations (3) and (4), the relationship between the phase difference $\Delta\theta_{F1}$ and the phase difference $\Delta\theta_{F2}$ is more generally controlled than in the second intermodulation distortion canceling operation mode.

The second amplifier 5 amplifies an input signal from the second signal source 3. At this time, due to nonlinearity of the second amplifier 5, a third-order intermodulation distortion and a seventh-order intermodulation distortion are generated in an output signal of the second amplifier 5. As a result, in the output signal of the second amplifier 5, a low-frequency third-order intermodulation distortion component having a phase of 0 degrees and a high-frequency third-order intermodulation distortion component having a phase of 0 degrees are included as a third-order intermodulation distortion component IM3'.

The output combiner 6 vector-combines the signal output from the first amplifier 4 and the signal output from the second amplifier 5, whereby combining is performed in such a manner that a phase difference between the low-frequency third-order intermodulation distortion components is -90 degrees - 0 degrees = -90 degrees. As a result, as indicated by an arrow A in FIG. 6, the low-frequency third-order intermodulation distortion component is not suppressed. Meanwhile, a phase difference between the high-frequency third-order intermodulation distortion components is 180 degrees - 0 degrees = 180 degrees, and combining is performed in opposite phases. As a result, as indicated by an arrow B in FIG. 6, the high-frequency third-order intermodulation distortion is suppressed.

Note that, in the above description, the first phase shifter 212 sets the angle of the phase of the first frequency F1 signal to 0 degrees, and the first phase shifter 312 sets the angle of the phase of the first frequency F1 signal to 0 degrees. However, the low distortion amplifier 1 is not limited to these phases. That is, in a case where the intermodulation distortion is generated, the phase difference $\Delta\theta_{F1}$ between the first frequency F1 signals only needs to be 0 degrees.

For example, the phase of the first frequency F1 signal input to the first amplifier 4 may be set to 60 degrees, and the phase of the first frequency F1 signal input to the second amplifier 5 may be set to 60 degrees.

In addition, in the above description, the second phase shifter 222 sets the angle of the phase of the second frequency F2 signal to 90 degrees, and second phase shifter 322 sets the angle of the phase of the second frequency F2 signal to 0 degrees. However, low distortion amplifier 1 is not limited to these phases. That is, in a case where the intermodulation distortion is generated, the phase difference $\Delta\theta_{F2}$ between the second frequency F2 signals only needs to be 90 degrees. For example, the phase of the second frequency F2 signal input to the first amplifier 4 may be set to 100 degrees, and the phase of the second frequency F2 signal input to the second amplifier 5 may be set to 10 degrees.

The output combiner 6 vector-combines the input signals, whereby the phase difference $\Delta\theta_{F1}$ between the fundamental wave signal having the first frequency F1 of the first amplifier 4 and the fundamental wave signal having the first frequency F1 of the second amplifier 5 is combined at 0 degrees, and the phase difference $\Delta\theta_{F2}$ between the

fundamental wave signal having the second frequency F2 of the first amplifier 4 and the fundamental wave signal having the second frequency F2 of the second amplifier 5 is combined at 90 degrees. As a result, only the high-frequency third-order intermodulation distortion is completely suppressed, whereas a power reduction amount of the fundamental wave signal is practically sufficient.

In addition, by performing control in such a manner that the magnitudes of the phase difference $\Delta\theta_{F1}$ and the phase difference $\Delta\theta_{F2}$ satisfy the above equation (6), the low distortion amplifier 1 can cancel the low-frequency third-order intermodulation distortion.

For example, by performing control in such a manner that the magnitudes of the phase difference $\Delta\theta_{F1}$ and the phase difference $\Delta\theta_{F2}$ satisfy the above equation (6) by setting m to 1, setting the phase difference $\Delta\theta_{F1}$ to 90 degrees, and setting the phase difference $\Delta\theta_{F2}$ to 0 degrees, the low distortion amplifier 1 can control a relative relationship between amplitudes of third-order harmonics, and can cancel the low-frequency third-order harmonic.

Furthermore, in a case where an intermodulation distortion of any order other than the low-frequency or high-frequency third-order harmonic is cancelled, by performing control in such a manner that the magnitudes of the phase difference $\Delta\theta_{F1}$ and the phase difference $\Delta\theta_{F2}$ satisfy the above equation (5) or (6), the intermodulation distortion can be cancelled.

For example, in a case where a low-frequency fifth-order harmonic is cancelled, by performing control in such a manner that the magnitudes of the phase difference $\Delta\theta_{F1}$ and the phase difference $\Delta\theta_{F2}$ satisfy the above equation (5) by setting n to 2, setting the phase difference $\Delta\theta_{F1}$ to 0 degrees, and setting the phase difference $\Delta\theta_{F2}$ to 60 degrees, a relative relationship between amplitudes of fifth-order harmonics can be controlled.

In the third intermodulation distortion canceling operation mode, it is possible to cancel an intermodulation distortion of any order and any band, and therefore as in the first or second intermodulation distortion canceling operation mode, the low distortion amplifier 1 can perform distortion compensation in which a ratio at which the intermodulation distortion component is suppressed is larger than a ratio at which the fundamental wave signal is deteriorated.

As described above, the low distortion amplifier 1 according to the first embodiment operates in an operation mode in which the phase difference $\Delta\theta_{F1}$ between the first frequency F1 signals input to the first amplifier 4 and the second amplifier 5 and the phase difference $\Delta\theta_{F2}$ between the second frequency F2 signals input to the first amplifier 4 and the second amplifier 5 satisfy a relational equation in which an intermodulation distortion component included in the signal amplified by the first amplifier 4 and an intermodulation distortion component included in the signal amplified by the second amplifier 5 are in opposite phases. As a result, when the signal amplified by the first amplifier 4 and the signal amplified by the second amplifier 5 are combined, only the intermodulation distortion components included in these signals are combined in opposite phases, and therefore the low distortion amplifier 1 can perform distortion compensation in which a ratio at which the intermodulation distortion component is suppressed is larger than a ratio at which a fundamental wave signal is deteriorated.

In the low distortion amplifier 1 according to the first embodiment, in a case where n and m are integers, a phase difference between the first frequency F1 signals is represented by $\Delta\theta_{F1}$, and a phase difference between the second frequency F2 signals is represented by $\Delta\theta_{F2}$, the relational equations are $((n+1)\Delta\theta_{F2} - n\Delta\theta_{F1}) = -+180$ degrees and $((m+1)\Delta\theta_{F1} - m\Delta\theta_{F2}) = +- 180$ degrees. As a result, the low distortion amplifier 1 operates in the third intermodulation distortion canceling operation mode, and can perform distortion compensation in which a ratio at which the intermodulation distortion component is suppressed is larger than a ratio at which the fundamental wave signal is deteriorated.

In the low distortion amplifier 1 according to the first embodiment, in a case where the order of the low-frequency intermodulation distortion is represented by $Y_{IML}$, the order of the high-frequency intermodulation distortion is represented by $Z_{IMH}$, the phase difference between the first frequency F1 signals is represented by $\Delta\theta_{F1}$, and the phase difference between the second frequency F2 signals is represented by $\Delta\theta_{F2}$, the relational equations are $(2 - (Y_{IML} - Z_{IMH}))/Y_{IML} + Z_{IMH} \times +-180$ degrees $= \Delta\theta_{F1}$ and $(2 + (Y_{IML} - Z_{IMH}))/Y_{IML} + Z_{IMH} \times -+180$ degrees $= \Delta\theta_{F2}$. As a result, the low distortion amplifier 1 operates in the second intermodulation distortion canceling operation mode, and can perform distortion compensation in which a ratio at which the intermodulation distortion component is suppressed is larger than a ratio at which the fundamental wave signal is deteriorated.

In the low distortion amplifier 1 according to the first embodiment, in a case where a phase difference between the first frequency F1 signals is represented by $\Delta\theta_{F1}$, a phase difference between the second frequency F2 signals is represented by $\Delta\theta_{F2}$, and the order of an intermodulation distortion is represented by $X_{IM}$, the relational equations are $+-180$ degrees$/X_{IM} = \Delta\theta_{F1}$ and $-+180$ degrees$/X_{IM} = \Delta\theta_{F2}$. As a result, the low distortion amplifier 1 operates in the first intermodulation distortion canceling operation mode, and can perform distortion compensation in which a ratio at which the intermodulation distortion component is suppressed is larger than a ratio at which the fundamental wave signal is deteriorated.

In addition, in the low distortion amplifier 1 according to the first embodiment, the first amplifier 4 and the second amplifier 5 are transistors having the same size. In addition, the first amplifier 4 and the second amplifier 5 are transistors under the same bias condition. As a result, the two amplifiers in the low distortion amplifier 1 can be in a parallel relationship, and the low distortion amplifier 1 can function as two input amplifiers.

Second Embodiment.

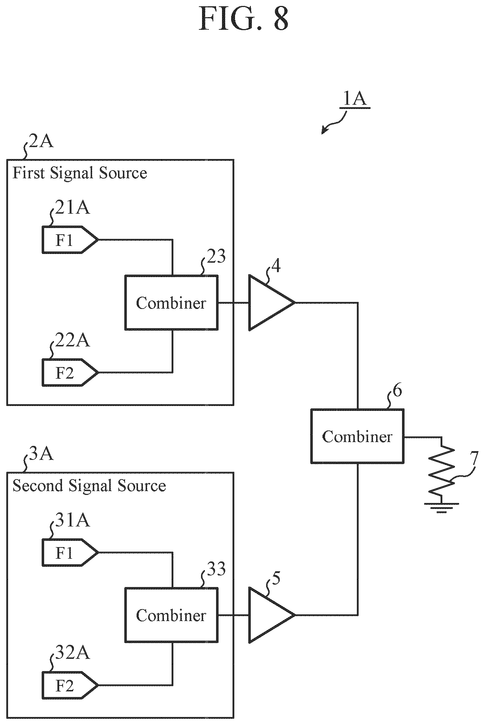

FIG. 8 is a block diagram illustrating a configuration example of a low distortion amplifier 1A according to a second embodiment. In FIG. 8, as in the first embodiment, the low distortion amplifier 1A can operate in first to third intermodulation distortion canceling operation modes and includes a first signal source 2A, a second signal source 3A, a first amplifier 4, a second amplifier 5, an output combiner 6, and an output terminal 7.

The first signal source 2A includes a signal source 21A that generates a first frequency F1 signal (fundamental wave signal having the first frequency F1), a signal source 22A that generates a second frequency F2 signal (fundamental wave signal having the second frequency F2), and a first input combiner 23. The second signal source 3A includes a signal source 31A that generates a first frequency F1 signal (fundamental wave signal having the first frequency F1), a signal source 32A that generates a second frequency F2 signal (fundamental wave signal having the second frequency F2), and a second input combiner 33. For example, an RFDAC may be used as each of the signal source 21A, the signal source 22A, the signal source 31A, and the signal source 32A.

The signal source 21A and the signal source 31A operate in synchronization under control of a control unit (not illustrated), and a relationship in an amplitude and a phase between the first frequency F1 signal generated by the signal source 21A and the first frequency F1 signal generated by the signal source 31A is controlled. Similarly for the signal source 22A and the signal source 32A, the signal source 22A and the signal source 32A operate in synchronization, and a relationship in an amplitude and a phase between the second frequency F2 signal generated by the signal source 22A and the second frequency F2 signal generated by the signal source 32A is controlled.

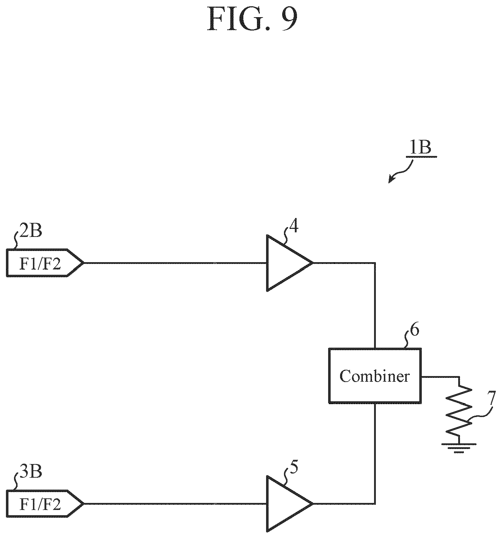

FIG. 9 is a block diagram illustrating a configuration of a low distortion amplifier 1B that is a modification of the low distortion amplifier 1A. In FIG. 9, the low distortion amplifier 1B includes a first signal source 2B, a second signal source 3B, the first amplifier 4, the second amplifier 5, the output combiner 6, and the output terminal 7, and each of the first signal source 2B and the second signal source 3B is constituted by an RFDAC.

As described above, in the low distortion amplifier 1A according to the second embodiment, each of the signal source 21A, the signal source 22A, the signal source 31A, and the signal source 32A is an RFDAC. In addition, in the low distortion amplifier 1B according to the second embodiment, each of the first signal source 2B and the second signal source 3B is an RFDAC. By using an RFDAC as the signal source, the low distortion amplifiers 1A and 1B can be achieved with a simple circuit configuration.

Third embodiment.

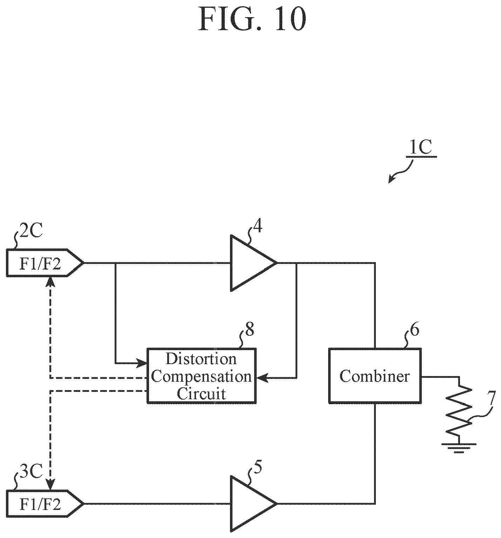

FIG. 10 is a block diagram illustrating a configuration example of a low distortion amplifier 1C according to a third embodiment. The low distortion amplifier 1C achieves low distortion compensation and widening of a band of two modulated waves without using a feedback reception system. As illustrated in FIG. 10, the low distortion amplifier 1C includes a first signal source 2C, a second signal source 3C, a first amplifier 4, a second amplifier 5, an output combiner 6, an output terminal 7, and a distortion compensation circuit 8.

The first signal source 2C generates a signal to be input to the first amplifier 4. The signal to be input to the first amplifier 4 includes a first frequency F1 signal (fundamental wave signal having the first frequency F1) and a second frequency F2 signal (fundamental wave signal having the second frequency F2). The second signal source 3C generates a signal to be input to the second amplifier 5. The signal to be input to the second amplifier 5 includes a first frequency F1 signal (fundamental wave signal having the first frequency F1) and a second frequency F2 signal (fundamental wave signal having the second frequency F2). For example, an RFDAC is used as each of the first signal source 2C and the second signal source 3C.

The first signal source 2C and the second signal source 3C operate in synchronization under control of a control unit (not illustrated), and a relationship in an amplitude and a phase between the first frequency F1 signal generated by the first signal source 2C and the first frequency F1 signal generated by the second signal source 3C is controlled. Similarly, a relationship in an amplitude and a phase between the second frequency F2 signal generated by the first signal source 2C and the second frequency F2 signal generated by the second signal source 3C is controlled.

The distortion compensation circuit 8 is a circuit that extracts, as a distortion, a difference between a theoretical value and an actual measurement value of an output signal of the first amplifier 4 in such a manner that a relationship between an input signal and the output signal of the first amplifier 4 is linear depending on a frequency band, and adds signal information that compensates for the distortion to the input signal. An input terminal of the distortion compensation circuit 8 is connected to an input terminal and an output terminal of the first amplifier 4, and an output terminal of the distortion compensation circuit 8 is connected to the first signal source 2C and the second signal source 3C.

It is assumed that the first signal source 2C and the second signal source 3C operate in synchronization, and amplitudes of the fundamental wave signals generated by the first signal source 2C and the second signal source 3C are equal to each other. Therefore, a distortion of a signal generated when the input signal is amplified through the first amplifier 4, extracted from the input signal and the output signal of the first amplifier 4 by the distortion compensation circuit 8 and signal information that compensates for the distortion can be included in each of a signal generated by the first signal source 2C and a signal generated by the second signal source 3C. Note that, for example, a digital pre-distortion (DPD) is used as the distortion compensation circuit 8.

As described above, the low distortion amplifier 1C according to the third embodiment includes the distortion compensation circuit 8 that adds, to a signal generated by the first signal source 2C and output to the first amplifier 4 and a signal generated by the second signal source 3C and output to the second amplifier 5, signal information that compensates for distortions generated in the signals. In the low distortion amplifier 1C, the distortion compensation circuit 8 can achieve low distortion compensation and widening of a band of two modulated waves without using a feedback reception system.

Note that, in the first to third embodiments, the case where the output combiner 6 is an analog circuit that combines a signal output from the first amplifier 4 and a signal output from the second amplifier 5 has been described, but it is not limited thereto. For example, the output combiner 6 may emit a signal output from the first amplifier 4 into space and may emit a signal output from the second amplifier 5 into space, thereby vector-combining these signals in space.

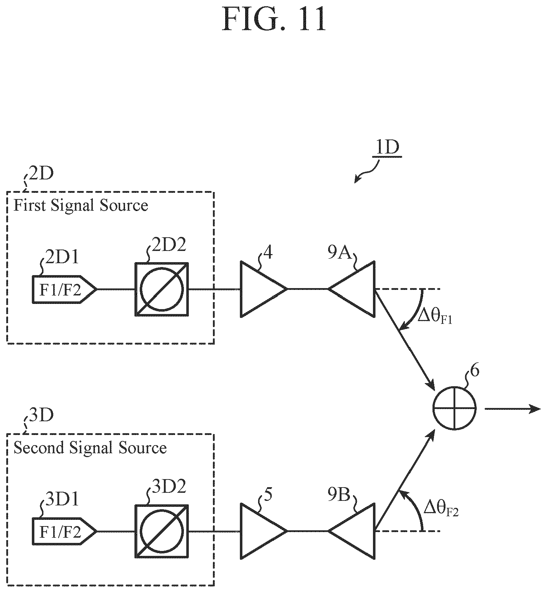

FIG. 11 is a block diagram illustrating a configuration of a low distortion amplifier 1D that is a modification of the low distortion amplifiers according to the first to third embodiments. As illustrated in FIG. 11, the low distortion amplifier 1D includes a first signal source 2D, a second signal source 3D, the first amplifier 4, the second amplifier 5, the output combiner 6, a first signal emitter 9A, and a second signal emitter 9B. The first signal source 2D is a signal source that generates a signal to be emitted from the first signal emitter 9A, and includes a signal generating unit 2D1 and a phase shifter 2D2. Note that the signal generating unit 2D1 operates similarly to the RFDAC illustrated in FIGS. 9 and 10. In addition, the phase shifter 2D2 operates similarly to the phase shifters 212, 222, 312, and 322 illustrated in FIG. 1.

The second signal source 3D is a signal source that generates a signal to be emitted from the second signal emitter 9B, and includes a signal generating unit 3D1 and a phase shifter 3D2. Note that the signal generating unit 3D1 operates similarly to the RFDAC illustrated in FIGS. 9 and 10. In addition, the phase shifter 3D2 operates similarly to the phase shifters 212, 222, 312, and 322 illustrated in FIG. 1.

A signal output from the first amplifier 4 is emitted into space as a first emission signal by the first signal emitter 9A, and a signal output from the second amplifier 5 is emitted into space as a second emission signal by the second signal emitter 9B. The angle of a beam array formed by the first signal emitter 9A is $\Delta\theta_{F1}$, and the first signal emitter 9A emits the first emission signal having the phase difference $\Delta\theta_{F1}$. The angle of a beam array formed by the second signal emitter 9B is $\Delta\theta_{F2}$, and the second signal emitter 9B emits a second emission signal having the phase difference $\Delta\theta_{F2}$. The output combiner 6 vector-combines the first emission signal and the second emission signal in space.

In addition, as a circuit that inputs a signal to each of the first amplifier 4 and the second amplifier 5, a circuit illustrated in any one of FIGS. 1 and 8 to 10 illustrated in the first to third embodiments may be used.

In this way, even the low distortion amplifier 1D configured to vector-combine a signal amplified by the first amplifier 4 and a signal amplified by the second amplifier 5 in space can obtain similar effects to those of the above-described first to third embodiments.

INDUSTRIAL APPLICABILITY

The low distortion amplifier according to the present disclosure can be used, for example, for mobile object communication.

REFERENCE SIGNS LIST

1, 1A, 1B, 1C, 1D: low distortion amplifier, 2, 2A, 2B, 2C, 2D: first signal source, 3, 3A, 3B, 3C, 3D: second signal source, 2D2, 3D2: phase shifter, 4: first amplifier, 5: second amplifier, 6: output combiner, 7: output terminal, 8: distortion compensation circuit, 9A: first signal emitter, 9B: second signal emitter, 21, 21A, 22, 22A, 31, 31A, 32, 32A: signal source, 23: first input combiner, 33: second input combiner, 211, 2D1, 3D1: signal generating unit, 212, 312: first phase shifter, 221, 311, 321: signal generating unit, 222, 322: second phase shifter

## Claims

1. A low distortion amplifier comprising:

   a first signal source (2,2A to 2C) to output a first frequency signal and a second frequency signal, the second frequency being different from the first frequency;
   a second signal source (3,3A to 3C) to output the first frequency signal and the second frequency signal;
   a first amplifier (4) to receive the signal output from the first signal source and to amplify the input signal;
   a second amplifier (5) to receive the signal output from the second signal source and to amplify the input signal;

and

a combiner (6) to combine the signal amplified by the first amplifier and the signal amplified by the second amplifier, wherein

an operation is performed in an operation mode in which a phase difference between the first frequency signals input to the first amplifier and the second amplifier and a phase difference between the second frequency signals input to the first amplifier and the second amplifier satisfy a relational equation in which an intermodulation distortion component included in the signal amplified by the first amplifier and an intermodulation distortion component included in the signal amplified by the second amplifier are in opposite phases,

**characterized in that** the low distortion amplifier further comprises a distortion compensation circuit (8) configured;

to extract, as a distortion, a difference between a theoretical value and an actual measurement value of an output signal of the first amplifier (4) in such a manner that a relationship between an input signal and the theoretical value of the output signal of the first amplifier (4) is linear depending on a frequency band; and

to add based on said difference, eeds to a signal generated by the first signal source and input to the first amplifier and a signal generated by the second signal source and input to the second amplifier, signal information compensating for the distortion generated in the signals.

2. The low distortion amplifier according to claim 1, wherein

in a case where n and m are integers, a phase difference between the first frequency signals is represented by $\Delta\theta_{F1}$, and a phase difference between the second frequency signals is represented by $\Delta\theta_{F2}$, the relational equations are $((n + 1)\Delta\theta_{F2} - n\Delta\theta_{F1}) = -+ 180$ degrees and $((m + 1)\Delta\theta_{F1} - m\Delta\theta_{F2}) = +- 180$ degrees.

3. The low distortion amplifier according to claim 1, wherein

in a case where an order of a low-frequency intermodulation distortion is represented by $Y_{IML}$, an order of a high-frequency intermodulation distortion is represented by $Z_{IMH}$, a phase difference between the first frequency signals is represented by $\Delta\theta_{F1}$, and a phase difference between the second frequency signals is represented by $\Delta\theta_{F2}$, the relational equations are $(2 - (Y_{IML} - Z_{IMH}))/Y_{IML} + Z_{IMH} \times +-180$ degrees $= \Delta\theta_{F1}$ and $(2 + (Y_{IML} - Z_{IMH}))/Y_{IML} + Z_{IMH} \times -+ 180$ degrees $= \Delta\theta_{F2}$.

4. The low distortion amplifier according to claim 1, wherein

in a case where a phase difference between the first frequency signals is represented by $\Delta\theta_{F1}$, a phase difference between the second frequency signals is represented by $\Delta\theta_{F2}$, and an order of an intermodulation distortion is $X_{IM}$, the relational equations are $+-180$ degrees$/X_{IM} = \Delta\theta_{F1}$ and $-+180$ degrees$/X_{IM} = \Delta\theta_{F2}$.

5. The low distortion amplifier according to claim 1, wherein

the first amplifier (4) and the second amplifier (5) are transistors having the same size.

6. The low distortion amplifier according to claim 1, wherein

the first amplifier (4) and the second amplifier (5) are transistors under the same bias condition.

7. The low distortion amplifier according to claim 1, wherein

each of the first signal source (2A) and the second signal source (3A) includes a signal source (21A,31A) to generate the first frequency signal and a signal source (22A,32A) to generate the second frequency signal, and the signal source to generate the first frequency signal and the signal source to generate the second frequency signal are digital-to-analog converters.

8. The low distortion amplifier according to claim 1, wherein

the first signal source (2B) and the second signal source (3B) are digital-to-analog converters.

9. The low distortion amplifier according to any one of claims 1 to 8, wherein

the combiner (6) emits a signal amplified by the first amplifier and a signal amplified by the second amplifier into space, and vector-combines these signals.

**Patentansprüche**

1. Verzerrungsarmer Verstärker, umfassend:

eine erste Signalquelle (2, 2A bis 2C), um ein erstes Frequenzsignal und ein zweites Frequenzsignal auszugeben, wobei sich die zweite Frequenz von der ersten Frequenz unterscheidet;

eine zweite Signalquelle (3, 3A bis 3C), um das erste Frequenzsignal und das zweite Frequenzsignal auszugeben;

einen ersten Verstärker (4), um das von der ersten Signalquelle ausgegebene Signal zu empfangen und das eingegebene Signal zu verstärken;

einen zweiten Verstärker (5), um das von der zweiten Signalquelle ausgegebene Signal zu empfangen und das eingegebene Signal zu verstärken; und

einen Kombinierer (6), um das durch den ersten Verstärker verstärkte Signal und das durch den zweiten Verstärker verstärkte Signal zu kombinieren, wobei

ein Betrieb in einem Betriebsmodus durchgeführt wird, in dem eine Phasendifferenz zwischen den ersten Frequenzsignalen, die in den ersten Verstärker und den zweiten Verstärker eingegeben werden, und eine Phasendifferenz zwischen den zweiten Frequenzsignalen, die in den ersten Verstärker und den zweiten Verstärker eingegeben werden, eine Beziehungsgleichung erfüllen, in der eine Intermodulationsverzerrungskomponente, die in dem durch den ersten Verstärker verstärkten Signal enthalten ist, und eine Intermodulationsverzerrungskomponente, die in dem durch den zweiten Verstärker verstärkten Signal enthalten ist, einen Bogen in entgegengesetzten Phasen bilden,

**dadurch gekennzeichnet, dass** der verzerrungsarme Verstärker außerdem eine Verzerrungskompensationsschaltung (8) umfasst, welche eingerichtet ist, um:

eine Differenz zwischen einem theoretischen Wert und einem tatsächlichen Messwert eines Ausgangssignals des ersten Verstärkers (4) als eine Verzerrung zu extrahieren, so dass eine Beziehung zwischen einem Eingangssignal und dem theoretischen Wert des Ausgangssignals des ersten Verstärkers (4) in Abhängigkeit von einem Frequenzband linear ist; und

auf der Grundlage dieser Differenz zu einem von der ersten Signalquelle erzeugten und in den ersten Verstärker eingegebenen Signal und einem von der zweiten Signalquelle erzeugten und in den zweiten Verstärker eingegebenen Signal Signalinformationen hinzuzufügen, welche die in den Signalen erzeugte Verzerrung kompensieren.

2. Verzerrungsarmer Verstärker nach Anspruch 1, wobei
in einem Fall, in dem n und m ganze Zahlen sind, eine Phasendifferenz zwischen den ersten Frequenzsignalen durch $\Delta\theta_{F1}$ dargestellt wird, und eine Phasendifferenz zwischen den zweiten Frequenzsignalen durch $\Delta\theta_{F2}$ dargestellt wird, die Beziehungsgleichungen $((n + 1)\Delta\theta_{F2} - n\Delta\theta_{F1}) = -+ 180$ Grad und $((m + 1)\Delta\theta_{F1} - m\Delta\theta_{F2}) = +- 180$ Grad lauten.

3. Verzerrungsarmer Verstärker nach Anspruch 1, wobei
in einem Fall, in dem eine Ordnung einer niederfrequenten Intermodulationsverzerrung durch $Y_{IML}$ dargestellt wird, eine Ordnung einer hochfrequenten Intermodulationsverzerrung durch $Z_{IMH}$ dargestellt wird, eine Phasendifferenz zwischen den ersten Frequenzsignalen durch $\Delta\theta_{F1}$ dargestellt wird, und eine Phasendifferenz zwischen den zweiten Frequenzsignalen durch $\Delta\theta_{F1}$ dargestellt wird, die Beziehungsgleichungen $(2 - (Y_{IML} - Z_{IMH}))/Y_{IML} + Z_{IMH} \times +-180$ Grad $= \Delta\theta_{F1}$ und $(2 + (Y_{IML} - Z_{IMH}))/Y_{IML} + Z_{IMH} \times -+180$ Grad $= \Delta\theta_{F2}$ lauten.

4. Verzerrungsarmer Verstärker nach Anspruch 1, wobei
in einem Fall, in dem eine Phasendifferenz zwischen den ersten Frequenzsignalen durch $\Delta\theta_{F1}$ dargestellt wird, eine Phasendifferenz zwischen den zweiten Frequenzsignalen durch $\Delta\theta_{F1}$ dargestellt wird, und eine Ordnung einer Intermodulationsverzerrung $X_{IM}$ ist, die Beziehungsgleichungen $+-180$ Grad$/X_{IM}=\Delta\theta_{F1}$ und $-+180$ Grad$/X_{IM}=\Delta\theta_{F2}$ lauten.

5. Verzerrungsarmer Verstärker nach Anspruch 1, wobei
der erste Verstärker (4) und der zweite Verstärker (5) Transistoren gleicher Größe sind.

6. Verzerrungsarmer Verstärker nach Anspruch 1, wobei
der erste Verstärker (4) und der zweite Verstärker (5) Transistoren unter dem gleichem Vorspannungszustand sind.

7. Verzerrungsarmer Verstärker nach Anspruch 1, wobei

jede von der ersten Signalquelle (2A) und der zweiten Signalquelle (3A) eine Signalquelle (21A, 31A) zur Erzeugung des ersten Frequenzsignals und eine Signalquelle (22A, 32A) zur Erzeugung des zweiten Frequenzsignals enthält, und

die Signalquelle zur Erzeugung des ersten Frequenzsignals und die Signalquelle zur Erzeugung des zweiten Frequenzsignals Digital-Analog-Wandler sind.

8. Verzerrungsarmer Verstärker nach Anspruch 1, wobei die erste Signalquelle (2B) und die zweite Signalquelle (3B) Digital-Analog-Wandler sind.

9. Verzerrungsarmer Verstärker nach einem der Ansprüche 1 bis 8, wobei der Kombinierer (6) ein durch den ersten Verstärker verstärktes Signal und ein von dem zweiten Verstärker verstärktes Signal in Raum emittiert, und diese Signale vektorkombiniert.

**Revendications**

1. Amplificateur à faible distorsion, comprenant :

une première source de signal (2,2A à 2C) pour délivrer en sortie un signal de première fréquence et un signal de seconde fréquence, la seconde fréquence étant différente de la première fréquence ;
une seconde source de signal (3,3A à 3C) pour délivrer en sortie le premier signal de fréquence et le second signal de fréquence ;
un premier amplificateur (4) pour recevoir le signal délivré en sortie par la première source de signal et pour amplifier le signal d'entrée ;
un second amplificateur (5) pour recevoir le signal délivré en sortie par la seconde source de signal et pour amplifier le signal d'entrée ; et
un combineur (6) pour combiner le signal amplifié par le premier amplificateur et le signal amplifié par le second amplificateur, dans lequel
une opération est effectuée dans un mode de fonctionnement dans lequel une différence de phase entre les signaux de première fréquence entrés dans le premier amplificateur et le second amplificateur et une différence de phase entre les signaux de seconde fréquence entrés dans le premier amplificateur et le second amplificateur satisfont une équation relationnelle dans laquelle une composante de distorsion d'intermodulation incluse dans le signal amplifié par le premier amplificateur et une composante de distorsion d'intermodulation incluse dans le signal amplifié par le second amplificateur sont dans des phases opposées,
**caractérisé en ce que** l'amplificateur à faible distorsion comprend en outre un circuit de compensation de distorsion (8) configuré ;
pour extraire, en tant que distorsion, une différence entre une valeur théorique et une valeur de mesure réelle d'un signal de sortie du premier amplificateur (4) de telle manière qu'une relation entre un signal d'entrée et la valeur théorique du signal de sortie du premier amplificateur (4) soit linéaire en fonction d'une bande de fréquences ; et
pour ajouter, sur la base de ladite différence, à un signal généré par la première source de signal et entré dans le premier amplificateur et à un signal généré par la seconde source de signal et entré dans le second amplificateur, des informations de signal compensant la distorsion générée dans les signaux.

2. Amplificateur à faible distorsion selon la revendication 1, dans lequel
dans un cas où n et m sont des entiers, une différence de phase entre les signaux de première fréquence est représentée par $\Delta\theta_{F1}$, et une différence de phase entre les signaux de seconde fréquence est représentée par $\Delta\theta_{F2}$, les équations relationnelles sont $((n + 1) \Delta\theta_{F2} - n\Delta\theta_{F1})$ =-+- 180 degrés et $((m + 1) \Delta\theta_{F1} - m \Delta\theta_{F2})$ =+- 180 degrés.

3. Amplificateur à faible distorsion selon la revendication 1, dans lequel
dans un cas où un ordre d'une distorsion d'intermodulation basse fréquence est représenté par $Y_{IML}$, un ordre d'une distorsion d'intermodulation haute fréquence est représenté par $Z_{IMH}$, une différence de phase entre les signaux de première fréquence est représentée par $\Delta\theta_{F1}$, et une différence de phase entre les signaux de seconde fréquence est représentée par $\Delta\theta_{F2}$, les équations relationnelles sont $(2 - (Y_{IML} - Z_{IMH}))/ Y_{IML} + Z_{IMH} X$ +-180 degrés = $\Delta\theta_{F1}$ et $(2 + (Y_{IML} - Z_{IMH}))/ Y_{IML} + Z_{IMH} x$ -+180 degrés = $\Delta\theta_{F2}$.

4. Amplificateur à faible distorsion selon la revendication 1, dans lequel
dans un cas où une différence de phase entre les signaux de première fréquence est représentée par $\Delta\theta_{F1}$, une différence de phase entre les signaux de seconde fréquence est représentée par $\Delta\theta_{F2}$, et un ordre d'une distorsion d'intermodulation est $X_{IM}$, les équations relationnelles sont +-180 degrés/ $X_{IM} = \Delta\theta_{F1}$ et -+180 degrés/ $X_{IM} = \Delta\theta_{F2}$.

5. Amplificateur à faible distorsion selon la revendication 1, dans lequel

le premier amplificateur (4) et le second amplificateur (5) sont des transistors présentant la même taille.

6. Amplificateur à faible distorsion selon la revendication 1, dans lequel
le premier amplificateur (4) et le second amplificateur (5) sont des transistors dans la même condition de polarisation.

7. Amplificateur à faible distorsion selon la revendication 1, dans lequel

chacune de la première source de signal (2A) et de la seconde source de signal (3A) inclut une source de signal (21A, 31A) pour générer le signal de première fréquence et une source de signal (22A, 32A) pour générer le signal de seconde fréquence, et
la source de signal pour générer le signal de première fréquence et la source de signal pour générer le signal de seconde fréquence sont des convertisseurs numériques-analogiques.

8. Amplificateur à faible distorsion selon la revendication 1, dans lequel
la première source de signal (2B) et la seconde source de signal (3B) sont des convertisseurs numériques-analogiques.

9. Amplificateur à faible distorsion selon l'une quelconque des revendications 1 à 8 ; dans lequel
le combineur (6) émet un signal amplifié par le premier amplificateur et un signal amplifié par le second amplificateur dans l'espace, et combine vectoriellement ces signaux.

# FIG. 1

# FIG. 2

# FIG. 3

# FIG. 4

# FIG. 5

# FIG. 6

# FIG. 7

# FIG. 8

# FIG. 9

# FIG. 10

FIG. 11

**EP 4 451 560 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2021314009 A1
- US 2002089373 A1
- JP 2007243491 A